(19) **Europäisches Patentamt / European Patent Office / Office européen des brevets**

(11) **EP 3 329 519 B1**

(12) # FASCICULE DE BREVET EUROPEEN

(45) Date de publication et mention
de la délivrance du brevet:
**17.02.2021 Bulletin 2021/07**

(21) Numéro de dépôt: **16744780.4**

(22) Date de dépôt: **28.07.2016**

(51) Int Cl.:
**H01L 31/05** *(2014.01)*   **H01L 31/18** *(2006.01)*

(86) Numéro de dépôt international:
**PCT/EP2016/068108**

(87) Numéro de publication internationale:
**WO 2017/021289 (09.02.2017 Gazette 2017/06)**

(54) **PROCÉDÉ DE FABRICATION D'UN MODULE PHOTOVOLTAÏQUE AYANT DES PERTES RÉSISTIVES FAIBLES**

VERFAHREN ZUR HERSTELLUNG EINES FOTOVOLTAIKMODULS MIT NIEDRIGEM WIDERSTANDSVERLUST

METHOD FOR MANUFACTURING A PHOTOVOLTAIC MODULE HAVING LOW RESISTIVE LOSS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.07.2015 FR 1557356**

(43) Date de publication de la demande:
**06.06.2018 Bulletin 2018/23**

(73) Titulaire: **Commissariat à l'Énergie Atomique et aux Énergies Alternatives
75015 Paris (FR)**

(72) Inventeurs:
• **BETTINELLI, Armand**
**38500 Coublevie (FR)**
• **LEFILLASTRE, Paul**
**75013 Paris (FR)**

(74) Mandataire: **Cabinet Camus Lebkiri
25 rue de Maubeuge
75009 Paris (FR)**

(56) Documents cités:
WO-A1-2013/020111        DE-A1-102008 043 833
DE-A1-102012 220 221     US-A1- 2003 127 124
US-A1- 2007 199 588      US-A1- 2007 294 883
US-A1- 2013 139 871

• SÖDERSTRÖM, T. ET AL: "Smart Wire Connection Technology", PROCEEDINGS OF THE 28TH EUROPEAN PHOTOVOLTAIC SOLAR ENERGY CONFERENCE AND EXHIBITION, 30 septembre 2013 (2013-09-30), - 4 octobre 2013 (2013-10-04), pages 495-499, XP040634884, DOI: 10.4229/28thEUPVSEC2013-1CV.2.17 ISBN: 978-3-936338-33-1 cité dans la demande

## Description

## DOMAINE TECHNIQUE

La présente invention concerne un procédé de fabrication d'un module photovoltaïque, dans lequel les cellules photovoltaïques sont divisées en sous-cellules et les sous-cellules sont connectées en série afin de diminuer le courant électrique généré par le module et d'élever la tension à ses bornes.

## ÉTAT DE LA TECHNIQUE

Un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées (ou « pseudo-carrées »), de 156 mm de côté, réparties en six « chaînes » (« strings » en anglais) de dix cellules connectées en série. Les six chaînes de cellules photovoltaïques sont également connectées en série. La tension de circuit ouvert aux bornes du module est alors égale à 60 fois la tension de seuil d'une cellule photovoltaïque. Par exemple, avec des cellules photovoltaïques à homojonction en silicium présentant une tension de seuil de l'ordre de 0,65 V, la tension de circuit ouvert aux bornes du module atteint 39 V environ.

Compte tenu que toutes les cellules photovoltaïques de ce module sont connectées en série, le courant électrique du module correspond approximativement au courant fourni par chaque cellule photovoltaïque (en pratique, les cellules photovoltaïques n'ont pas exactement les mêmes performances et le courant électrique est limité par la cellule la moins performante du module). Avec les dernières technologies de cellules photovoltaïques, notamment la technologie PERT (pour « Passivated Emitter and Rear Totally diffused » en anglais), le courant d'une cellule monofaciale de 156 x 156 mm$^2$ en superficie atteint des valeurs élevées, de l'ordre de 9 A pour une irradiance solaire de 1000 W/m$^2$. Ces valeurs de courant sont augmentées d'environ 20 % lorsqu'on utilise une cellule bifaciale, du fait du rayonnement solaire diffus capté en face arrière de la cellule.

Les porteurs de charge photogénérés, qui contribuent au courant électrique de la cellule photovoltaïque, sont collectés grâce à un réseau d'électrodes déposé sur la face avant de la cellule. Ces électrodes, appelées également doigts de collecte, sont étroites (<100 μm). Elles sont généralement formées par sérigraphie d'une pâte contenant de l'argent. La face arrière de la cellule est soit recouverte d'un autre réseau d'électrodes (cas des cellules bifaciales), soit d'une couche métallique pleine, par exemple en aluminium (cas des cellules monofaciales). Le courant électrique circule ensuite d'une cellule à l'autre de la chaîne par des interconnexions.

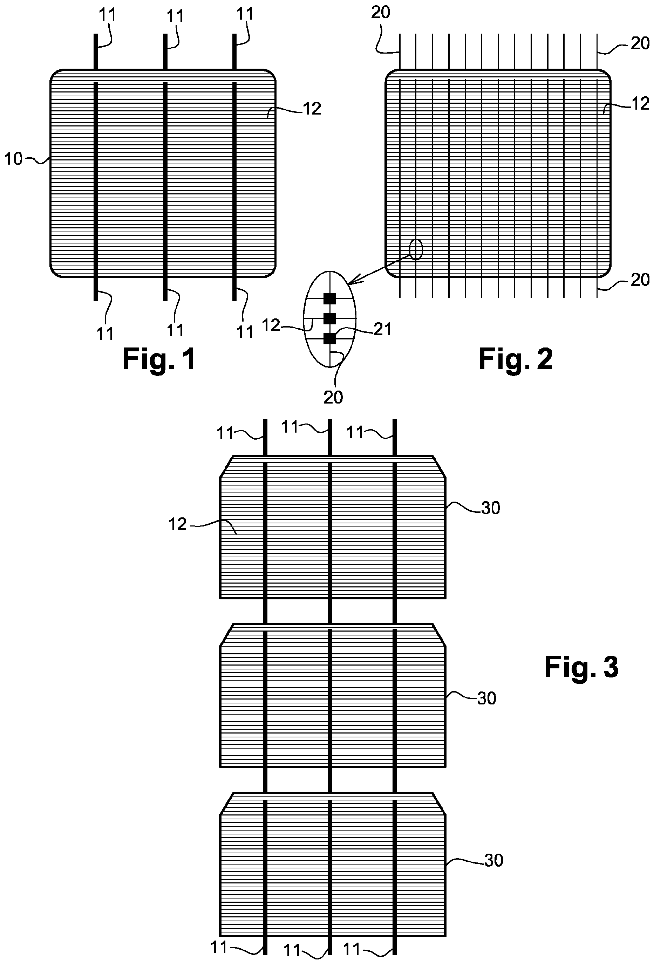

On distingue aujourd'hui deux techniques majeures pour interconnecter les cellules photovoltaïques d'une chaîne : les interconnexions en forme de ruban et les interconnexions en forme de fil électrique. Ces deux techniques sont représentées par les figures 1 et 2 respectivement.

Sur la figure 1, les interconnexions entre les cellules 10 sont constituées de rubans 11 en cuivre recouverts d'un alliage fusible, typiquement un alliage d'étain et de plomb ou un alliage d'étain et d'argent. Ces rubans 11 de section rectangulaire sont soudés sur des pistes conductrices appelées « busbars » et formées en même temps que les doigts de collecte 12 par sérigraphie. Les busbars relient électriquement les doigts de collecte 12 et sont orientés perpendiculairement aux doigts de collecte 12.

Une cellule de 156 mm x 156 mm compte généralement trois rubans de 1,5 mm de large ou quatre rubans de 1,2 mm de large, ces rubans ayant une épaisseur de l'ordre de 0,2 mm. Chaque ruban 11 connecte la face avant d'une cellule 10 à la face arrière de la cellule suivante dans la chaîne (non représentée sur la figure 1). La mise en série des cellules photovoltaïques 10 au moyen des rubans 11 s'effectue de façon entièrement automatisée, dans un équipement appelé « stringer ».

Plusieurs équipementiers proposent dorénavant de remplacer les rubans de cuivre par des fils électriques de plus faible section. Par exemple, la technologie « Multi-Busbar » développée par la société « Schmid » et décrite dans l'article [« Multi-busbar solar cells and modules: high efficiencies and low silver consumption », S. Braun et al., Energy Procedia, vol. 38, pp. 334-339, 2013] multiplie le nombre de busbars déposés sur la cellule, passant de trois à quinze busbars, et soude à chaque busbar un fil de 200 μm de diamètre. Cette technologie est schématisée sur la figure 2. Les fils 20 sont constitués de cuivre et recouverts d'une fine couche d'un alliage à base d'étain-plomb ou d'étain-argent dont le point de fusion est situé au-dessus de 170 °C. Les busbars ont une forme discontinue. Ils se composent de plots de métallisation 21, d'environ 500 μm x 700 μm, alignés sur les doigts de collecte 12. Les plots de métallisation 21 et les doigts de collecte 12 sont généralement réalisés par sérigraphie d'une pâte d'argent. La soudure des fils 20 sur les plots 21 a lieu immédiatement après avoir posé les fils sur les plots, dans le même équipement, en chauffant ces éléments à une température de l'ordre de 200 °C. Ainsi, l'alliage recouvrant les fils de cuivre est fondu.

La technologie « SmartWire » développée par la société « Meyer Burger » et décrite dans l'article [« Smart Wire Connection Technology », T. Söderström et al., Proceedings of the 28th European Photovoltaics Solar Energy Conference, pp.495-499, 2013] consiste à déposer une nappe de 18 à 36 fils de 200 μm ou 300 μm de diamètre directement sur les doigts de collecte. Autrement dit, les cellules photovoltaïques sont dépourvues de busbars. Les fils sont tenus par un film support en polytéréphtalate d'éthylène (PET), qui est collé sur chaque face des cellules. Les fils ont une âme en cuivre et un revêtement extérieur formé d'un alliage à base d'indium. Cet alliage possède une température de fusion inférieure à 150 °C, ce qui permet de réaliser la connexion électrique entre les fils et les doigts de collecte, non pas lors de l'étape d'interconnexion des cellules (par chauffage localisé vers 200 °C), mais lors de l'étape de lamination des modules photovoltaïques (qui se fait à plus basse température, généralement vers 150-160 °C).

Les interconnexions en forme de fil électrique permettent de réduire la longueur des doigts de collecte par rapport à la configuration à trois busbars (Fig.1), car le nombre de fils est plus important que le nombre de rubans. Cette augmentation du nombre d'interconnexions n'a pas nécessairement d'impact sur l'ombrage de la cellule photovoltaïque en raison de la plus petite taille des fils. Par contre, elle permet de réduire considérablement la quantité d'argent utilisée pour imprimer les doigts de collecte. En effet, les doigts de collecte étant moins long, on peut soit réduire la largeur des doigts soit utiliser une pâte moins riche en argent (et donc moins conductrice) pour une résistance série équivalente. En outre, grâce à leur section circulaire, les fils électriques ont un ombrage effectif sur la cellule photovoltaïque égal à 70 % seulement de leur diamètre, contre 100 % de la largeur des rubans. Ainsi, pour un ensemble d'interconnexions ayant une même section transversale, le taux d'ombrage sur des cellules interconnectées par fils est plus faible que celui sur des cellules interconnectées par rubans.

Les doigts de collecte sont à l'origine de pertes résistives qui détériorent le facteur de forme (FF, pour « Fill Factor » en anglais) de la cellule photovoltaïque, et donc son rendement. Pour rappel, le facteur de forme FF représente « l'écart » de la caractéristique I-V réelle de la cellule par rapport à une caractéristique idéale rectangulaire. Son expression est la suivante :

$$ FF = \frac{P_{opt}}{I_{CC} \times V_{CO}} $$

où $P_{opt}$ est la puissance fournie par la cellule au point de fonctionnement optimal de la caractéristique I-V réelle, $I_{CC}$ est le courant de court-circuit et $V_{CO}$ est la tension de circuit ouvert. Le rendement $\eta$ de la cellule est lié au facteur de forme FF par la relation suivante :

$$ \eta = \frac{V_{co}.I_{cc}.FF}{P_i} $$

où $P_i$ est la puissance du rayonnement solaire incident.

À ces pertes résistives au niveau de la cellule, il faut ajouter les pertes résistives au niveau du module, i.e. dans les interconnexions. Les pertes résistives dans les interconnexions sont proportionnelles au carré du courant électrique I généré par le module et à la résistance série $R_S$ des interconnexions, qui dépend notamment de la section de cuivre utilisée.

Une solution pour diminuer ces pertes résistives consisterait donc à augmenter la section des rubans ou fils de cuivre pour diminuer leur résistance série $R_S$. Toutefois, cette solution est rarement mise en œuvre en raison de deux inconvénients majeurs. Augmenter la section de cuivre (notamment via son épaisseur) entraînerait une augmentation des contraintes mécaniques dans les interconnexions (dues à la différence des coefficients de dilatation thermique entre le cuivre et le silicium), ce qui nuirait à la fiabilité des modules. L'augmentation de la section de cuivre via sa largeur aurait un impact négatif sur le taux d'ombrage des cellules photovoltaïques.

La figure 3 illustre une façon plus efficace de diminuer les pertes résistives dans les interconnexions, en connectant en série des demi-cellules 30, c'est-à-dire des moitiés de cellules photovoltaïques, plutôt que des cellules entières. En effet, en divisant par deux la surface des cellules élémentaires qui composent les chaînes du module, le courant électrique du module est également divisé par deux. Les pertes résistives dans les interconnexions sont alors réduites d'un facteur quatre. Le nombre de cellules élémentaires dans le module est généralement multiplié par deux, afin de doubler la tension aux bornes du module et conserver la même taille de module.

Les demi-cellules 30 sont produites en coupant des cellules photovoltaïques entières 10 parallèlement aux doigts de collecte 12 (cf. Fig.1), par exemple au moyen d'un laser. Puis, les demi-cellules 30 sont connectées en série de la même façon que des cellules entières. Des équipements de type stringer adaptés au format des demi-cellules sont aujourd'hui commercialisés pour former des chaînes de demi-cellules, comme celle représentée sur la figure 3. Ces équipements fonctionnent avec des rubans de cuivre 11 selon les configurations usuelles à 3 ou 4 busbars.

Ainsi, plutôt qu'un module comprenant 60 cellules photovoltaïques de taille standard (par exemple 156 mm x 156 mm), on peut fabriquer un module comprenant 120 demi-cellules (de 156 mm x 78 mm) toutes connectées en série. Les modules à base de demi-cellules ont généralement un meilleur facteur de forme que les modules à base de cellules entières, et par conséquent, une puissance électrique $P_{opt}$ supérieure (à surface de cellules constante).

En contrepartie de ces meilleures performances, la cadence des lignes de fabrication de modules photovoltaïques est réduite de moitié, car le stringer doit manipuler un nombre deux fois plus élevé de cellules élémentaires.

On voit alors que les équipements actuels constituent un frein à l'obtention de modules photovoltaïques ayant des valeurs de courant encore plus faible, et donc des pertes résistives très limitées. En effet, si la cadence de production est divisée par deux en utilisant des demi-cellules, elle est divisée par quatre en connectant en série des quarts de cellule découpés parallèlement aux doigts de collecte. Or développer de nouveaux équipements est non seulement long et risqué pour les équipementiers, mais cela obligerait en outre les fabricants de modules photovoltaïques à remplacer leur parc de machines.

Par ailleurs, les documents WO2013/020111, US2013/139871 et DE102008043833 décrivent des procédés permettant de fabriquer des modules photovoltaïques souples et de haute tension. Ces procédés prévoient également d'utiliser des sous-cellules découpées dans des cellules photovoltaïques de pleine taille. La découpe est réalisée au moyen d'un laser, après avoir collé sur la face avant de la cellule photovoltaïque des feuilles en verre ou Téflon aux dimensions des sous-cellules. La prise de contact en face arrière est formée pour chaque sous-cellule après son découpage. Puis, les cellules sont interconnectées en série et laminées entre des plaques avant et arrière souples. Des systèmes d'interconnexion de cellules photovoltaïques dans un module sont décrits dans DE102012220221, US2007294883 et US2003127124.

## RÉSUMÉ DE L'INVENTION

Il existe un besoin, tant pour les fabricants de module que pour leurs équipementiers, de pouvoir fabriquer des modules photovoltaïques de plus faible courant électrique, sans avoir à changer entièrement les équipements actuels et sans réduire davantage la cadence de production de ces modules.

Selon un premier aspect de l'invention, on tend à satisfaire ce besoin en prévoyant un procédé de fabrication de module photovoltaïque selon la revendication 1 comprenant successivement les étapes suivantes :

- prévoir des cellules photovoltaïques comportant des doigts de collecte ;
- découper les cellules photovoltaïques selon une première direction perpendiculaire aux doigts de collecte pour former une pluralité de sous-cellules ;
- aligner des sous-cellules dans une deuxième direction perpendiculaire à la première direction, de façon à constituer des groupes de sous-cellules isolées électriquement, chaque groupe de sous-cellules ayant une dimension dans la deuxième direction sensiblement identique à la dimension des cellules photovoltaïques dans la deuxième direction ;
- aligner les groupes de sous-cellules dans la première direction, en manipulant un par un les groupes de sous-cellules, et interconnecter les groupes de sous-cellules de façon à former une pluralité de chaînes de sous-cellules connectées en série, les sous-cellules de chaque groupe appartenant à des chaînes de sous-cellules différentes ; et
- connecter électriquement en série les chaînes de sous-cellules.

Pour fabriquer de façon plus économique des modules photovoltaïques de faible courant électrique, on propose un procédé dans lequel des morceaux de cellules photovoltaïques appelés « sous-cellules » sont disposés à proximité les uns des autres et manipulés par groupe afin de former simultanément plusieurs chaînes de sous-cellules. À l'inverse, dans les procédés de fabrication de l'art antérieur, les chaînes de sous-cellules sont formées une par une, car les sous-cellules (découpées dans un même sens, parallèlement aux doigts de collecte) sont manipulées individuellement.

Grâce au fait que les groupes de sous-cellules conservent l'une des dimensions standards des cellules photovoltaïques (par exemple la dimension « 156 mm »), les stringers actuels peuvent être utilisés pour connecter en série les sous-cellules de chaque chaîne. Ces équipements requièrent seulement quelques modifications mineures pour manipuler les groupes de sous-cellules, au lieu de demi-cellules ou de cellules entières. Ainsi, les équipementiers pourront adapter à moindre coût les machines existantes et répondre efficacement aux besoins de modules photovoltaïques à faible courant électrique.

Par exemple, en découpant chaque cellule photovoltaïque en 2, 3 ou 4 sous-cellules selon la première direction uniquement, c'est-à-dire perpendiculairement aux doigts de collecte de la cellule, le procédé selon l'invention permet de former respectivement 2, 3 ou 4 chaînes de sous-cellules en autant de temps qu'une chaîne de cellules entières, en utilisant un stringer de cellules entières. La cadence de production des modules photovoltaïques est alors élevée. Dans le cas des modules « demi-cellules » notamment, elle est doublée par rapport au procédé de fabrication de l'art antérieur.

Dans un mode de mise en œuvre préférentiel du procédé selon l'invention, les cellules photovoltaïques sont découpées une fois selon la deuxième direction, i.e. parallèlement aux doigts de collecte, et au moins une fois selon la première direction, i.e. perpendiculairement aux doigts de collecte. Ainsi, lorsque le découpage des cellules a lieu d'abord dans la deuxième direction, on obtient deux demi-cellules (de même superficie) au sein desquelles sont ensuite découpées les sous-cellules.

Ce mode de mise en œuvre permet de former plusieurs chaînes constituées de sous-cellules, de format plus petit que celui des demi-cellules, en autant de temps qu'une chaîne de demi-cellules grâce à un stringer de demi-cellules. Ainsi, on peut fabriquer des modules photovoltaïques aux valeurs de courant plus faibles encore que celle d'un module demi-cellules, sans diminuer davantage la cadence de production.

Le procédé selon l'invention peut également présenter une ou plusieurs des caractéristiques ci-dessous, considérées individuellement ou selon toutes les combinaisons techniquement possibles :

- les groupes de sous-cellules sont interconnectés deux par deux au moyen de rubans électriques de sorte que chaque face des sous-cellules soit en contact avec au moins un ruban ;

- les rubans électriques ont une largeur inférieure ou égale à 1 mm et une épaisseur inférieure ou égale à 180 μm ;
- les groupes de sous-cellules sont interconnectés deux par deux au moyen de fils électriques de sorte que chaque face des sous-cellules soit en contact avec une pluralité de fils électriques ;
- les fils électriques sont solidaires d'un support en matériau polymère et contactent les doigts de collecte des sous-cellules ;
- les groupes de sous-cellules sont interconnectés en plaquant une feuille de support de part et d'autre de chaque groupe de sous-cellules, les fils électriques étant répartis à la surface de chaque feuille de support en contact avec le groupe de sous-cellules, et dans lequel les feuilles de support sont ultérieurement découpées pour séparer les différentes chaînes de sous-cellules ;
- les groupes de sous-cellules sont interconnectés en plaquant plusieurs morceaux distincts du support de part et d'autre de chaque groupe de sous-cellules, des fils électriques étant répartis à la surface de chaque morceau du support en contact avec le groupe de sous-cellules, et dans lequel chaque morceau du support appartient à une seule chaîne de sous-cellules ;
- les fils électriques ont un diamètre inférieur ou égal à 200 μm ;
- les sous-cellules appartenant aux chaînes de sous-cellules connectées en série sont d'un même type et orientées dans un même sens ;
- les sous-cellules appartenant à une première chaîne et les sous-cellules appartenant à une deuxième chaîne adjacente à la première chaîne sont de types opposés ou orientées dans des sens opposés ;
- les sous-cellules appartenant aux chaînes de sous-cellules connectées en série sont de même superficie ;
- les sous-cellules d'un groupe sont originaires de la même cellule photovoltaïque ; et
- chaque groupe de sous-cellules comprend 2, 3, 4 ou 5 sous-cellules.

Un deuxième aspect de l'invention concerne un système selon la revendication 11 permettant d'interconnecter des portions de cellule photovoltaïque, les portions de cellule photovoltaïque comprenant des doigts de collecte orientés perpendiculairement à une première direction. Ce système comporte :

- une station de chargement configurée pour distribuer des groupes de plusieurs portions de cellule isolées électriquement et alignées dans une deuxième direction perpendiculaire à la première direction, chaque groupe de portions de cellule ayant une dimension dans la deuxième direction sensiblement identique à la dimension de la cellule photovoltaïque dans la deuxième direction ;

- une station d'assemblage des groupes de portions de cellule en une pluralité de chaînes de portions de cellule ;
- une première unité de transfert configurée pour appréhender chaque groupe de portions de cellule et déplacer ledit groupe de portions de cellule de la station de chargement vers la station d'assemblage.

Le système d'interconnexion selon l'invention peut également présenter une ou plusieurs des caractéristiques ci-dessous, considérées individuellement ou selon toutes les combinaisons techniquement possibles :

- la première unité de transfert comprend des buses d'aspiration configurées pour aspirer simultanément toutes les portions de cellule dudit groupe ;
- le système d'interconnexion comprend une station de découpe de cellules photovoltaïques en portions de cellule, située en amont de la station de chargement ;
- le système d'interconnexion comprend un module de distribution de fils électriques solidaires d'un support et dans lequel la station d'assemblage est configurée pour lier mécaniquement le support des fils électriques aux groupes de portions de cellule ;
- le système d'interconnexion comprend un dispositif de découpe configuré pour découper le support des fils électriques après l'assemblage des groupes de portions de cellule, de manière à séparer les chaînes de portions de cellule ;
- le système d'interconnexion comprend une deuxième unité de transfert configurée pour saisir individuellement chacune des chaînes de portions de cellule issues de la station d'assemblage et pour tourner à 180° ladite chaîne saisie ; et
- le système d'interconnexion comprend une deuxième unité de transfert configurée pour saisir collectivement plusieurs chaînes de portions de cellule issues de la station d'assemblage, pour libérer une première partie desdites chaînes saisies et pour tourner à 180° une deuxième partie restante desdites chaînes saisies.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- les figures 1 et 2 représentent schématiquement deux techniques d'interconnexion de cellules photovoltaïques selon l'art antérieur ;
- la figure 3 représente une chaîne de cellules élémentaires d'un module photovoltaïque selon l'art antérieur, où les cellules élémentaires sont constituées de demi-cellules ;

- les figures 4A à 4E représentent des étapes de fabrication d'un module photovoltaïque comprenant une multitude de sous-cellules, d'après un mode de mise en œuvre préférentiel du procédé selon l'invention ;

- la figure 5C représente une variante de mise en œuvre de l'étape d'interconnexion des sous-cellules représentée à la figure 4C ;

- la figure 6 représente un module photovoltaïque obtenu à l'issue d'une variante du procédé de fabrication selon l'invention, les sous-cellules de ce module n'étant pas orientées de la même façon ; et

- la figure 7 représente schématiquement un deuxième mode de mise en œuvre du procédé de fabrication selon l'invention.

Pour plus de clarté, les éléments identiques ou similaires sont repérés par des signes de références identiques sur l'ensemble des figures.

## DESCRIPTION DÉTAILLÉE D'AU MOINS UN MODE DE RÉALISATION

Dans la description qui suit, on appelle « chaîne de sous-cellules » une succession de sous-cellules photovoltaïques reliés mécaniquement et destinées à être connectées électriquement en série. Les sous-cellules désignent des morceaux de cellule découpés dans des cellules photovoltaïques de pleine taille.

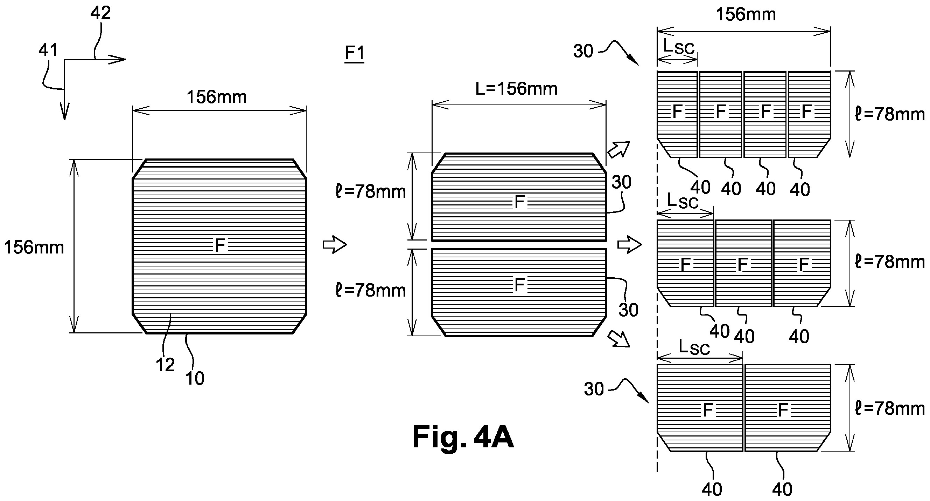

Un premier mode de mise en œuvre préférentiel du procédé de fabrication de module photovoltaïque selon l'invention va maintenant être décrit en référence aux figures 4A à 4E. La face F des cellules et sous-cellules photovoltaïques représentées sur ces figures est la face avant, c'est-dire la face destinée à être exposée au rayonnement solaire incident. Dans le cas particulier de cellules bifaciales, comme les deux faces peuvent capter le rayonnement solaire, la face avant est celle permettant d'obtenir le maximum de courant électrique lorsqu'elle est tournée vers le rayonnement incident.

La figure 4A illustre une première étape F1 du procédé de fabrication dans laquelle des cellules photovoltaïques 10 de pleine taille sont découpées pour former des sous-cellules 40. Les cellules photovoltaïques 10 sont munies au moins en face avant F d'un réseau de doigts de collecte 12. Les doigts de collecte 12 sont, de façon classique, répartis sur toute la surface des cellules 10. Ils sont tous orientés perpendiculairement à une première direction 41.

Les cellules photovoltaïques 10 ont au préalable été fabriquées à partir de substrats semi-conducteurs, par exemple en silicium. Elles ont de préférence une forme carrée ou, comme représentée sur la figure 4A, une forme pseudo-carrée. Dans le format pseudo-carré, les quatre coins des cellules 10 sont tronqués ou arrondis. Les cellules photovoltaïques 10 sont de dimensions standards, par exemple 156 mm x 156 mm.

Dans ce mode de mise en œuvre préférentiel, les cellules photovoltaïques 10 sont d'abord découpées en deux parties 30 de même superficie, appelées « demi-cellules », selon une deuxième direction 42 parallèle aux doigts de collecte 12. On obtient ainsi deux moitiés de cellules ayant une longueur L égale à 156 mm et une largeur l égale à 78 mm. La largeur des demi-cellules 30 et des sous-cellules 40 est mesurée dans la première direction 41 et leur longueur est mesurée dans la deuxième direction 42.

Chaque demi-cellule 30 est ensuite découpée selon la première direction 41 en plusieurs sous-cellules 40. Ce découpage est avantageusement réalisé de sorte que toutes les sous-cellules 40 aient la même superficie. Ainsi, les sous-cellules produiront sensiblement le même courant électrique et une chaîne formée de ces sous-cellules ne verra pas son courant limité par une sous-cellule plus petite. Lorsque la cellule photovoltaïque 10 initiale est au format pseudo-carré, les sous-cellules 40 correspondant aux côtés de la demi-cellule 30 ont une longueur $L_{sc}$ légèrement plus grande que celle des sous-cellules prélevées à l'intérieur de la demi-cellule, afin de compenser leur coin tronqué. Lorsque la cellule photovoltaïque 10 initiale est au format carré, les sous-cellules 40 ont toutes la même longueur $L_{sc}$.

À titre d'exemple, chaque sous-cellule 40 représente un quart de la superficie d'une cellule photovoltaïque entière 10 lorsque les demi-cellules 30 ont été découpées en deux (à droite en bas de la figure 4A), un sixième de la superficie d'une cellule 10 lorsque les demi-cellules 30 ont été découpées en trois (à droite au milieu de la figure 4A), et un huitième de la superficie d'une cellule 10 lorsque les demi-cellules 30 ont été découpées en quatre (à droite en haut de la figure 4A).

Le découpage des sous-cellules 40 peut être réalisé de différentes manières, par exemple par sciage, en formant un sillon avec un laser puis en clivant la cellule, ou par une technique laser appelée TLS (pour « Thermal Laser Séparation » en anglais) qui repose sur une séparation thermique initiée par un laser. La technique TLS est particulièrement avantageuse, car le laser utilisé ne provoque pas la fusion du silicium. En outre, le découpage d'une cellule photovoltaïque 10 peut être réalisé en une seule opération grâce à cette technique. Ainsi, il n'est pas obligatoire de découper d'abord la cellule photovoltaïque 10 en demi-cellules 30 pour obtenir les sous-cellules 40.

Dans le cas d'utilisation d'un laser, le faisceau grave avantageusement le côté opposé à l'émetteur de la cellule photovoltaïque 10 à découper, de sorte à éviter les risques de court-circuit. Le clivage peut être obtenu dans l'alignement des zones fragilisées par le laser, par exemple en appuyant sur ces zones avec un matériau élastomère, lorsque la cellule photovoltaïque est posée sur un support non-plan. Alternativement, on peut utiliser un dispositif à parties mobiles qui, en maintenant par dépression chacune des futures sous-cellules, permet d'exercer des contraintes de flexion sur des axes de rupture de la cellule par un mouvement contrôlé des parties mobiles. Du fait du maintien de chacune des sous-cellules, on peut contrôler la disposition des sous-cellules issues d'une même cellule photovoltaïque, ce qui facilite l'étape suivante du procédé.

Le découpage est avantageusement réalisé de façon entièrement automatisée par un robot faisant partie de la ligne de production des modules photovoltaïques, soit en amont du stringer, i.e. l'équipement destiné à former les chaînes de sous-cellules, soit au sein même du stringer. Autrement dit, le stringer peut comporter une station de découpe des cellules photovoltaïques en sous-cellules conformément à l'étape F1.

Les sous-cellules 40 obtenues à l'issue de l'étape F1 sont avantageusement triées, par exemple par photoluminescence (pour détecter les sous-cellules fissurées) et/ou en fonction de leurs caractéristiques I-V, afin d'écarter les sous-cellules susceptibles de limiter les performances du module photovoltaïque. Les sous-cellules 40 possédant un angle tronqué pourront également être séparées de celles qui en sont dépourvues, afin de réaliser deux types de module.

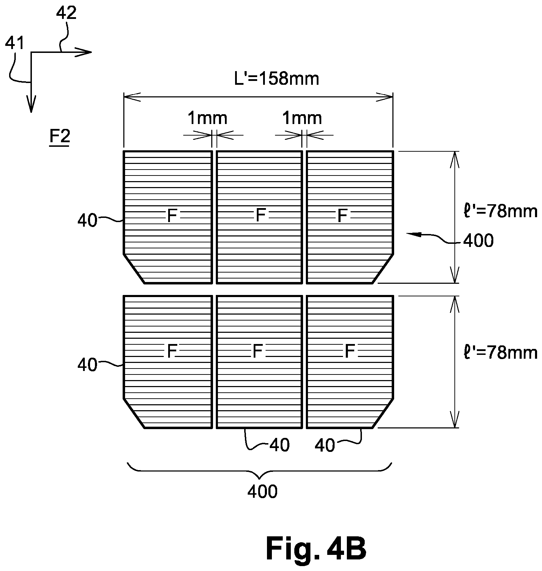

À l'étape F2 représentée par la figure 4B, les sous-cellules 40 sont alignées dans la deuxième direction 42 pour former des groupes 400 de sous-cellules. Les sous-cellules 40 de chaque groupe 400 sont séparées les unes des autres d'une faible distance, par exemple de 1 mm, afin d'être isolées électriquement. Le nombre de sous-cellules au sein de chaque groupe 400 varie en fonction de leur longueur $L_{sc}$. En effet, les sous-cellules 40 sont disposées de telle façon que les groupes 400 de sous-cellules aient une longueur L' sensiblement identique à la longueur L des demi-cellules 30 (ici L'=158 mm, au lieu de L=156 mm). La largeur l' des groupes 400 de sous-cellules est égale à la largeur l des demi-cellules (78 mm), elle-même égale à la largeur des sous-cellules 40 (cf. Fig.4A).

Autrement dit, à l'étape F2, on reconstitue une demi-cellule 30, en juxtaposant autant de sous-cellules 40 qu'il en a été découpé dans la demi-cellule 30. Dans l'exemple représenté sur la figure 4B, les demi-cellules 30 ont été découpées en trois, chaque groupe 400 contient par conséquent trois sous-cellules 40.

La répartition des sous-cellules 40 en groupes 400 peut être réalisée par un robot muni d'un bras de préhension associé à un dispositif vibrant à encoches et, éventuellement, d'un dispositif de détection optique lui permettant de visualiser les sous-cellules avant de s'en saisir. Le bras de préhension saisit les sous-cellules issues de la station de découpage et les pose dans les encoches du dispositif vibrant placées en position inclinée. Les vibrations couplées à la pente font glisser les sous-cellules le long des encoches dont la largeur diminue jusqu'à une dimension juste supérieure à celles des sous-cellules, ces encoches étant séparées de l'espacement voulu pour les sous-cellules. De préférence, ce robot fait partie du stringer, et plus particulièrement de la station de chargement chargée de distribuer les groupes de sous-cellules. Au contraire, lorsqu'il s'agit d'un équipement spécifique, une manipulation supplémentaire des groupes de sous-cellules est nécessaire afin d'être amenés jusqu'à la station de chargement du stringer. La disposition des sous-cellules dans le groupe risque d'être modifiée et le risque de casse des sous-cellules est plus élevé.

Afin de limiter au maximum les transferts de sous-cellules entre le poste de découpage et le poste de formation des groupes 400, et donc les risques de casse de ces sous-cellules, les sous-cellules d'un groupe 400 sont prélevées au sein d'une même demi-cellule 30. En d'autres termes, juste après avoir été découpées, les sous-cellules sont regroupées.

Lorsque le système de découpe permet de positionner directement les sous-cellules 40 en forme de groupes 400, dans le cas du dispositif à parties mobiles décrit précédemment ou de l'équipement TLS par exemple, le système de découpe est avantageusement connecté à la station de chargement du stringer de sorte à conserver la position des sous-cellules.

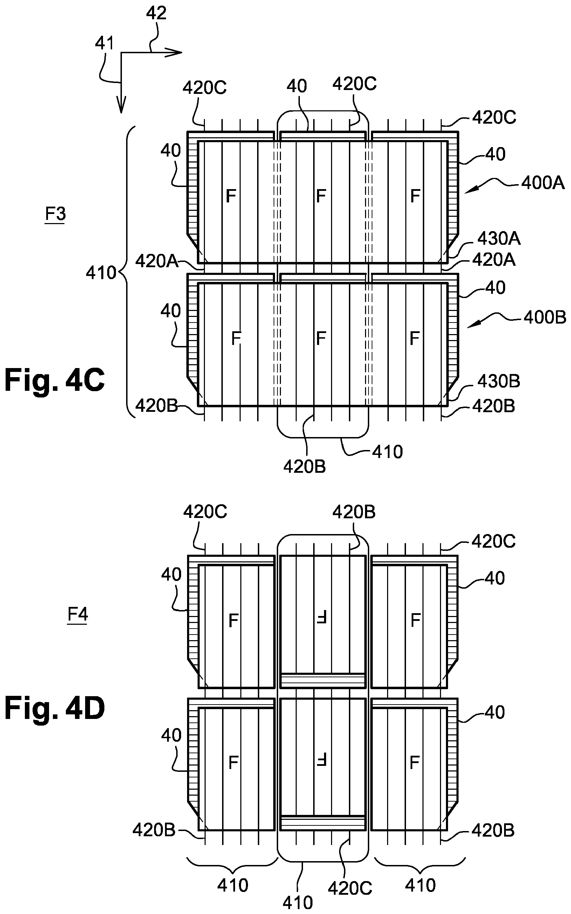

Puis, à l'étape F3 de la figure 4C, le stringer manipule à l'aide d'un robot ou unité de transfert les groupes de sous-cellules, comme il le ferait avec des demi-cellules, pour former simultanément plusieurs chaînes 410 de sous-cellules. Grâce au fait que les groupes de sous-cellules ont quasiment les mêmes dimensions que les demi-cellules, la manipulation des groupes plutôt que des demi-cellules ne pose aucune difficulté. Elle ne requiert que quelques modifications mineures sur le robot de transfert d'un stringer adapté au format des demi-cellules. En particulier, la configuration des buses d'aspiration des demi-cellules est modifiée pour saisir simultanément les sous-cellules de chaque groupe. On peut prévoir une ou plusieurs buses d'aspiration par sous-cellule. Compte tenu du faible gabarit des sous-cellules, les buses d'aspiration sont disposées de sorte que chaque buse aspire une sous-cellule 40 vers son centre. Le dispositif de détection optique du stringer peut aussi être adapté pour bien situer les groupes 400 de sous-cellules.

Les groupes 400 de sous-cellules sont ainsi transférés par le robot depuis la station de chargement vers une station d'assemblage, pour y être interconnectés. Les chaînes 410 de sous-cellules sont constituées en connectant deux par deux des sous-cellules 40 provenant de groupes 400 différents. Les connexions s'effectuent dans la première direction 41. Ainsi, les sous-cellules 40 de chaque groupe appartiennent à des chaînes 410 différentes.

Ce mode de connexion est décrit en détail ci-dessous en référence à la figure 4C qui, dans un souci de clarté, ne montre que deux groupes consécutifs de sous-cellules. Ces groupes portent les références 400A et 400B. Ainsi, les chaînes 410 de sous-cellules seront dans cet exemple limitées à deux sous-cellules.

Des interconnexions 420A sont d'abord disposées sur le premier groupe 400A de sous-cellules. Les interconnexions 420A s'étendent dans la première direction 41 et ont une longueur égale à deux fois environ la largeur des sous-cellules 40. Ainsi, une partie seulement des interconnexions 420A est en contact avec la face avant des sous-cellules 40 appartenant au premier groupe 400A. Ensuite, le deuxième groupe 400B de sous-cellules est disposé dans le prolongement du premier groupe 400A sur la partie non-occupée des interconnexions 420A. Celles-ci se trouvent alors en contact avec la face arrière des sous-cellules 40 appartenant au deuxième groupe 400B.

Des interconnexions 420B plus courtes que les interconnexions 420A, par exemple réduites de moitié, sont dans cet exemple disposées sur la face avant du groupe 400B. La mise en place des interconnexions 420B correspond à l'opération pour terminer une chaîne de sous-cellules (string). De même, la face arrière du groupe 400A avait été amenée en début de séquence (lors de la manipulation du groupe 400A par le stringer) en contact avec des interconnexions 420C d'une demi-longueur, ce qui correspond à l'opération pour démarrer une chaîne de sous-cellules. Ces interconnexions 420B et 420C constituent ici les extrémités des chaînes 410 de sous-cellules.

Les chaînes 410 comprennent bien souvent plus de deux demi-cellules afin d'élever suffisamment la tension aux bornes du module photovoltaïque. Les opérations de mise en place des groupes de sous-cellules et des interconnexions sont alors reproduites plusieurs fois en fonction du nombre de sous-cellules à connecter en série. Les interconnexions 420B déposées sur le groupe de cellules 400B sont alors identiques aux interconnexions 420A, puis un troisième groupe de sous-cellules (non représenté) est disposé sur la partie libre des interconnexions 420B, etc.

En d'autres termes, au cours de l'étape F3, les groupes de sous-cellules sont progressivement alignés dans la première direction 41, en les manipulant un par un. Entre deux manipulations successives, des interconnexions sont disposées sur le dernier groupe de sous-cellules de la chaîne. Ces interconnexions s'étendent dans la première direction 41 et sont réparties de façon homogène à la surface des groupes, ce qui permet de former simultanément plusieurs chaînes de sous-cellules 410 indépendantes électriquement.

Les interconnexions peuvent être de différentes natures selon la technique d'interconnexion utilisée.

Une première technique consiste à utiliser des rubans conducteurs électriquement de section rectangulaire, par exemple en cuivre. Cette technique est aujourd'hui parfaitement maitrisée pour des cellules photovoltaïques entières et des demi-cellules et fait appel à des équipements qui sont répandus et abordables. Les rubans sont répartis dessus et dessous les groupes de sous-cellules de façon à ce que chaque face des sous-cellules est en contact avec au moins un ruban. Le nombre de rubans électriques utilisés pour relier deux groupes consécutifs de sous-cellules est avantageusement de 3 ou 4.

Par exemple, avec un stringer à 4 rubans, on pourra obtenir soit deux chaînes 410 constituées de quarts de cellule (78 mm x 78 mm) connectés (deux à deux) par deux rubans, soit quatre chaînes 410 constituées de huitièmes de cellules (39 mm x 78 mm) connectés par un seul ruban. Avec un stringer à 3 rubans, trois chaînes 410 de sous-cellules (78 mm x 52 mm) peuvent être obtenues simultanément, chaque chaîne ne contenant qu'un seul ruban dans la deuxième direction 42.

De façon alternative, des techniques d'interconnexion par fils conducteurs électriquement peuvent être employées. Les groupes de sous-cellules sont notamment compatibles avec la technologie « Multi-Busbar » développée par la société « Schmid » et la technologie « SmartWire » développée par la société « Meyer Burger ». Les fils conducteurs de section circulaire constituent des interconnexions plus avantageuses que les rubans, car elles réduisent la quantité d'argent nécessaire pour imprimer les doigts de collecte (du fait de leur plus grand nombre) et causent un ombrage plus faible, à section de conducteur identique. Des modules moins coûteux et plus performants peuvent donc être obtenus grâce à ce type d'interconnexions.

Comme les rubans, les fils électriques sont dans la technologie « Multi-Busbar » déposés sur des busbars discontinus formés en face avant des sous-cellules 40 et éventuellement en face arrière (dans le cas de cellules photovoltaïques bifaciales). Dans chaque chaîne 410, les sous-cellules 40 sont connectées deux à deux par plusieurs fils électriques qui s'étendent dans la première direction 41.

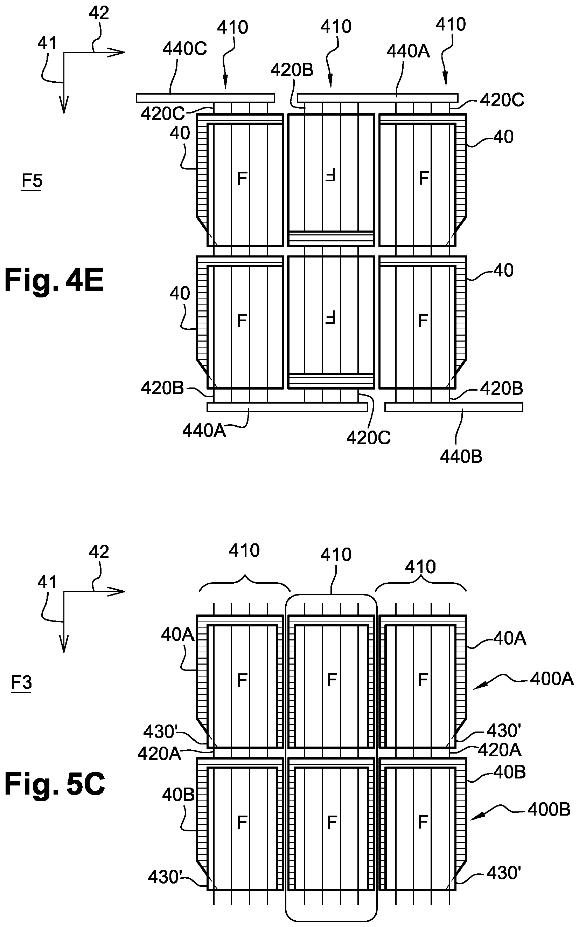

Avec cette technologie, les fils électriques sont soudés sur les bus localisés des sous-cellules lors de la réalisation des chaînes (chauffage localisé vers 200°C pour fusionner l'alliage enrobant les fils). Les fils deviennent alors solidaires des sous-cellules. Dès lors que les fils ont été soudés, la présence de plusieurs fils dans la deuxième direction 42 évite que les chaînes 410 ne se vrillent, en tournant autour de la première direction 41. À l'inverse, les chaînes 410 ne comportant qu'un seul ruban dans la deuxième direction 42 risquent de tourner sur elles-mêmes lorsqu'elles seront manipulées pour être connectées en série (étapes des figures 4D et 4E).

Dans le mode de mise en œuvre préférentiel représenté sur la figure 4C, les interconnexions 420A-420C sont des fils électriques solidaires d'un support, à la façon d'une nappe, et entrent directement en contact avec les doigts de collecte, conformément à la technologie « SwartWire ». Les sous-cellules 40 peuvent dans ce cas être dépourvues de busbars, ce qui représente une économie supplémentaire sur le coût du module photovoltaïque (et donc un avantage par rapport à la technologie « Multi-Busbar »). Le support des fils électriques est de préférence un film souple en matériau polymère, par exemple en polytéréphtalate d'éthylène (PET).

Comme représenté sur la figure 4C, le support des fils électriques 420A reliant les deux groupes adjacents 400A-400B est de préférence distribué sous la forme de deux feuilles 430A successives ayant des dimensions voisines de celles des demi-cellules. La première feuille de support 430A est plaquée contre la face avant du groupe 400A et la deuxième feuille de support (non visible sur la figure 4C) est plaquée contre la face arrière du groupe 400B. Les fils 420A s'étendent à la surface de la première feuille 430A disposée en regard de la face avant du groupe 400A, puis à la surface de la seconde feuille disposée en regard de la face arrière du groupe 400B. Les feuilles de support sont ainsi disposées du côté des fils permettant le contact électrique des fils avec les doigts des sous-cellules. Entre les deux groupes de sous-cellules 400A-400B, les fils électriques 420 sont libérés de leur support, ce qui leur permet de passer de la face avant du groupe 400A à la face arrière du groupe 400B. L'espace entre les groupes de sous-cellules 400A-400B est par exemple de 2,5 mm, ce qui constitue l'espace usuel entre cellules pour des chaînes classiques avec des interconnexions rubans. Avec des fils, cet espace peut être avantageusement réduit.

Les fils électriques 420B et 420C formant les extrémités des chaînes 410 ne sont tenus que par une seule feuille de support 430B, plaquée respectivement sur la face avant du groupe 400B et sur la face arrière du groupe 400A.

Les feuilles de support sont, de préférence, collées de chaque côté des groupes de sous-cellules en chauffant légèrement le matériau polymère (par exemple vers 100 °C). Toutefois, malgré cette opération, le contact électrique entre les fils 420A-420C et les doigts de collecte n'est pas encore établi. Le contact électrique s'opère de préférence lors d'une étape ultérieure de lamination des modules photovoltaïques, grâce au fait que les fils électriques sont enrobés d'une couche en un alliage ayant une température de fusion légèrement inférieure à 150°C, par exemple un alliage à base d'indium.

Outre le fait qu'elle permet de diminuer considérablement le coût de fabrication des cellules, la technique d'interconnexion « SmartWire » est également la plus avantageuse d'un point de vue de la fiabilité des modules photovoltaïques. En effet, dans la technologie « Multi-Busbar », le contact électrique entre les fils électriques et les sous-cellules est réalisé par le stringer, avant la mise en série des chaînes de sous-cellules. Par conséquent, des contraintes mécaniques importantes s'exercent sur ces contacts électriques lors de la manipulation des chaînes de sous-cellules. Certains des contacts pourraient se rompre, c'est pourquoi des busbar discontinus sont nécessaires sur la cellule. Au contraire, dans la technologie « SmartWire », la présence du support en polymère améliore la tenue mécanique de chaînes de sous-cellules. En effet, grâce au collage des fils sur les supports et des supports sur les sous-cellules, les fils ne peuvent plus se déplacer. Il n'y a donc pas de risque de rompre des liaisons mécaniques « fils - doigts de collecte » pendant la manipulation des chaînes de sous-cellules. Cela est d'autant plus important que les liaisons électriques « fils - doigts de collecte » ne sont pas encore formées à cette étape si l'opération d'assemblage des chaînes a bien été réalisée en dessous du point de fusion de l'alliage enrobant les fils.

Pour mettre en œuvre la technologie d'interconnexion « SmartWire », le stringer comporte un module de distribution des fils électriques, par exemple sous la forme d'un tambour autour duquel sont enroulés les fils électriques et leur support. Ce module alimente en interconnexions la station d'assemblage au fur et à mesure que les groupes de sous-cellules arrivent à cette station. La station d'assemblage est configurée pour lier mécaniquement le support des fils électriques aux groupes de sous-cellules. Elle comporte notamment un dispositif de pressage chauffant pour chauffer le support des fils et le coller aux sous-cellules.

Après que les groupes de sous-cellules aient été reliés mécaniquement en chaînes ou « guirlandes », les différentes chaînes 410 de sous-cellules sont désolidarisées les unes des autres, en découpant les feuilles de support 430A-430B au niveau de l'espace qui séparent les sous-cellules d'un groupe. Les chaînes 410 peuvent alors être manipulées individuellement. Ce découpage du support peut être réalisé au moyen de couteaux, de préférence en forme de disque rotatif, appartenant au stringer. Le stringer peut aussi être équipé d'un laser pour découper le support des fils.

Quelle que soit la technique d'interconnexion par fils employée à l'étape F3, les fils 420A sont avantageusement séparés dans la deuxième direction 42 d'une distance inférieure à 20 mm, de préférence comprise entre 4 mm et 12 mm. En effet, réduire la distance entre fils permet de relever les contraintes de résistance de doigts de collecte. On utilisera donc avantageusement une distance comprise entre 4 mm et 12 mm, les distances les plus petites étant associées aux fils les plus fins pour limiter l'ombrage. Ainsi, des sous-cellules de 39 mm de longueur ($L_{sc}$ = 39 mm) comprennent entre quatre fils de 150 $\mu$m de diamètre et neuf fils de 100 $\mu$m de diamètre.

Dans le mode de mise en œuvre préférentiel des figures 4A à 4E, les sous-cellules 40 des chaînes 410 sont toutes orientées de la même façon et toutes du même type, par exemple tirées de cellules photovoltaïques en silicium à émetteur standard dopé de type n. Dans une cellule photovoltaïque à émetteur standard, l'émetteur (i.e. la couche mince dopée d'un type de dopage opposé à celui du substrat) est situé en face avant de la cellule. À l'inverse, dans une cellule à émetteur inversé, l'émetteur se situe en face arrière de la cellule. Ainsi, le type d'une cellule/sous-cellule peut faire référence à l'emplacement de l'émetteur dans la cellule/sous-cellule. On distinguera également deux types de cellules/sous-cellules en fonction du type de dopage du substrat (n ou p). En effet, une cellule à émetteur standard formée à partir d'un substrat de type n peut être considérée de type opposé à une autre cellule à émetteur standard formée à partir d'un substrat de type p. Une orientation identique signifie que toutes les sous-cellules 40 ont leur face avant F orientées du même côté, par exemple vers le haut (i.e. en direction du soleil).

Dans ces conditions, on voit sur la figure 4C que les interconnexions 420B formant les extrémités de deux chaînes 410 adjacentes sont de la même polarité. En effet, elles sont toutes connectées à la face avant des sous-cellules appartenant au groupe 400A. Il en est de même des interconnexions 420C plaquées contre la face arrière des sous-cellules appartenant au groupe 400B. Il paraît donc judicieux de tourner à 180° l'une des deux chaînes de sous-cellules avant de les connecter en série.

Ainsi, à l'étape F4 de la figure 4D, on effectue une rotation à 180° d'une chaîne 410 de sous-cellules 40 toutes les deux chaînes, sans toutefois changer son orientation. Dans l'exemple de module photovoltaïque représenté sur la figure 4C, qui ne compte que trois chaînes 410, la chaîne du milieu est tournée à 180°. Les extrémités 420C de la chaîne centrale 410 se retrouvent alors du côté opposé, avec de part et d'autre des interconnexions 420B de polarité opposée.

Cette opération de rotation peut être réalisée par un deuxième robot ou unité de transfert qui saisit une par une les chaînes de sous-cellules en sortie de la station d'assemblage, afin de les poser côte à côte sur une plaque de protection en verre constituant la face avant du module photovoltaïque. De façon classique, la plaque de protection constituée du verre face avant du module est recouverte d'une feuille de matériau d'encapsulation, avant d'y disposer les chaînes de sous-cellules.

Enfin, à l'étape F5 de la figure 4E, les différentes chaînes 410 de sous-cellules sont connectées en série, en plaçant par exemple à chaque extrémité des chaînes, un ruban conducteur 440A qui s'étend dans la deuxième direction 42 sur les interconnexions 420B-420C de deux chaînes 410 adjacentes. Des rubans conducteurs 440B et 440C peuvent en outre être reliés respectivement aux interconnexions 420B de la dernière chaîne 410 de la série (à droite sur la figure 4E) et aux interconnexions 420C de la première chaîne 410 de la série (à gauche sur la figure 4E). Les conducteurs 440B et 440C constituent avantageusement les bornes du module photovoltaïque.

Alternativement, le deuxième robot de transfert peut être configuré pour saisir simultanément plusieurs chaînes 410 de sous-cellules, les passer éventuellement sous un dispositif de mise à longueur des chaînes, en poser certaines sur la plaque de protection en verre, tourner à 180° les chaînes de sous-cellules restantes, c'est-à-dire celles qui n'ont pas été relâchées par le robot de transfert, puis poser les chaînes de sous-cellules restantes à côté des chaînes déjà positionnées sur la plaque de protection. Par exemple, dans le cas de quatre chaînes de sous-cellules 410 formées simultanément et agencées en parallèle, le robot de transfert saisit les quatre chaînes, pose la première et la troisième sur la plaque de protection, tourne la deuxième et la quatrième à 180° puis les pose à côté des première et troisième chaînes en respectant l'ordre initial des chaînes de sous-cellules.

Ce deuxième robot comprend au moins un groupe de buses d'aspiration configuré pour saisir individuellement chacune des chaînes de sous-cellules, plutôt qu'une chaîne de demi-cellules ou une chaîne de cellules entières. Dans le cas d'une manipulation collective des chaînes, le robot comprend avantageusement plusieurs groupes de buses d'aspiration. Les buses d'aspiration de chaque groupe sont commandées simultanément et disposées de façon à aspirer et maintenir chaque sous-cellule de la chaîne saisie. Par contre, les différents groupes peuvent être contrôlés indépendamment les uns des autres afin de saisir et relâcher une partie seulement des chaînes de sous-cellules.

Le deuxième robot de transfert peut être un module couplé à la station d'assemblage du stringer, et donc faire partie d'un même système, ou bien constituer un équipement distinct situé entre le stringer et la station de layup dans la ligne de production des modules photovoltaïques. La station de layup désigne l'emplacement où sont transférées les chaînes de sous-cellules 410 et où l'on assemble le module photovoltaïque. Après les avoir disposées sur la plaque de protection avant du module, les chaînes de sous-cellules 410 sont connectées en série (étape F5), puis recouvertes d'une deuxième feuille de matériau d'encapsulation et d'une deuxième plaque de protection constituant la face arrière du module.

La figure 5C représente une variante de mise en œuvre de l'étape F3 d'interconnexions des sous-cellules (étape dite de « stringing »), dans le cadre de la technologie « SmartWire ».

Plutôt que de découper les feuilles de support après les avoir plaquées contre les faces des groupes de sous-cellules, les feuilles de support ont été découpées préalablement, i.e. avant l'étape F3, dans la première direction 41 en plusieurs morceaux 430'. Les morceaux 430' ont globalement les dimensions d'une sous-cellule 40. Ils sont reliés deux à deux par des interconnexions 420A : un morceau issu de la première feuille avec un morceau issu de la seconde feuille. Ainsi, le stringer n'est plus alimenté par des paires de feuilles au format « demi-cellule », mais par une pluralité de bandes ou guirlandes comprenant chacune deux morceaux de support 430' et une partie des interconnexions 420A.

À l'étape F3, les morceaux 430' sont ensuite plaqués contre les faces des sous-cellules, de préférence selon la même séquence que les feuilles de support 430A (Fig.4C). Par exemple, pour connecter une sous-cellule 40A appartenant au groupe 400A à une sous-cellule 40B appartenant au groupe 400B, un morceau de support 430' est plaqué contre la face avant de la sous-cellule 40A et l'autre morceau (non visible sur la figure 5C) est plaqué contre la face arrière de la sous-cellule 40B (lorsque le groupe 400B est posé sur les interconnexions 420A).

Cette variante de mise en œuvre de l'étape F3 permet d'obtenir directement des chaînes de sous-cellules indépendantes les unes des autres mais complexifie l'équipement de préparation des nappes de fils. Les étapes F4 et F5 (dites de « layup ») permettant la connexion en série des chaînes de sous-cellules 410 peuvent ensuite être mises en œuvre de la même façon que décrite précédemment, en relation avec les figures 4D et 4E.

Une façon d'éviter la rotation des chaînes de sous-cellules à l'étape F4 de la figure 4C et l'opération de découpage des feuilles de support (avant ou après l'étape F3) consiste à utiliser des sous-cellules de type ou d'orientation opposé entre deux chaînes de sous-cellules 410 adjacentes. En effet, il n'est plus utile dans ces deux cas se séparer les chaînes de sous-cellules 410 formées simultanément à l'étape F3, car la polarité des interconnexions 420B (ou des interconnexions 420C) alterne en passant d'une chaîne à l'autre. Elles peuvent donc être déplacées ensemble vers la station de layup, où elles sont interconnectées par les rubans conducteurs 440A.

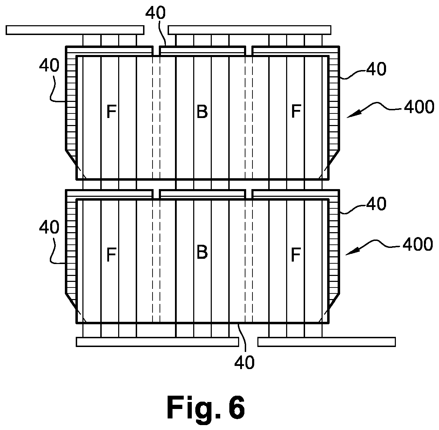

La figure 6 représente schématiquement l'une de ces variantes de mise en œuvre du procédé de fabrication. Les sous-cellules 40 des chaînes 410 sont toutes du même type mais leur orientation diffère. À l'étape F2 de constitution des groupes 400, les sous-cellules sont disposées de façon à ce qu'une sous-cellule sur deux des groupes 400 est orientée dans le sens opposé. Dans l'exemple de groupes de trois sous-cellules (Fig.6E), la sous-cellule au centre des groupes 400 peut être disposée face arrière B tournée vers le haut, alors que les deux sous-cellules sur les bords ont leur face avant F tournée vers le haut.

Cette première variante du procédé de fabrication, valable uniquement dans le cas de cellules bifaciales, montrent des performances (en termes de puissance électrique du module photovoltaïque) moindres que celles du cas précédent, où toutes les sous-cellules sont de même type et de même orientation. En effet, il est rare de tirer exactement le même courant électrique d'une cellule bifaciale quelle que soit l'orientation de cette cellule. Le courant est plus faible lorsque la face arrière est exposée au rayonnement solaire incident. Cet écart en courant peut être évité en modifiant les dimensions des sous-cellules selon qu'elles sont utilisées en face avant ou en face arrière mais le courant résultant sera plus faible.

La diminution du courant des chaînes de cellules, causée par les cellules dont la face arrière B est tournée vers le haut, peut être limitée en n'utilisant que des cellules photovoltaïques ayant un taux de bifacialité élevé, supérieur à 95 %. Le taux de bifacialité désigne le ratio entre le courant électrique généré par la cellule lorsque sa face avant est exposée au rayonnement solaire incident et le courant généré par cette même cellule lorsque la face arrière est exposée au même rayonnement.

Comme indiqué précédemment, les mêmes avantages peuvent être obtenus en alternant les types de sous-cellules d'une chaîne 410 à l'autre, mais en les orientant de la même façon. Par exemple, les sous-cellules d'une chaîne 410 peuvent être à émetteur standard et les sous-cellules de la (ou des) chaîne(s) 410 adjacente(s) sont à émetteur inversé. L'émetteur se situe alors tantôt en face avant, tantôt en face arrière des sous-cellules. Toutes les sous-cellules peuvent autrement avoir leur émetteur du même côté, mais être formées sur des substrats de types de dopage opposés. L'important est d'avoir deux familles de sous-cellules ayant des faces avant F de polarités différentes.

Cette seconde variante du procédé de fabrication selon l'invention présente l'avantage supplémentaire de pouvoir fonctionner aussi bien avec des cellules bifaciales qu'avec des cellules monofaciales. Par contre, elle requiert, à la différence des propositions précédentes, de gérer deux productions distinctes de cellules photovoltaïques. Comme ces cellules n'ont pas nécessairement les mêmes performances, le courant électrique généré par le module électrique peut être plus faible que dans le cas de sous-cellules de même type (et de même orientation).

Les deux variantes du procédé de fabrication décrites ci-dessus peuvent être mise en œuvre quelle que soit la nature des interconnexions, en forme de ruban ou de fil électrique.

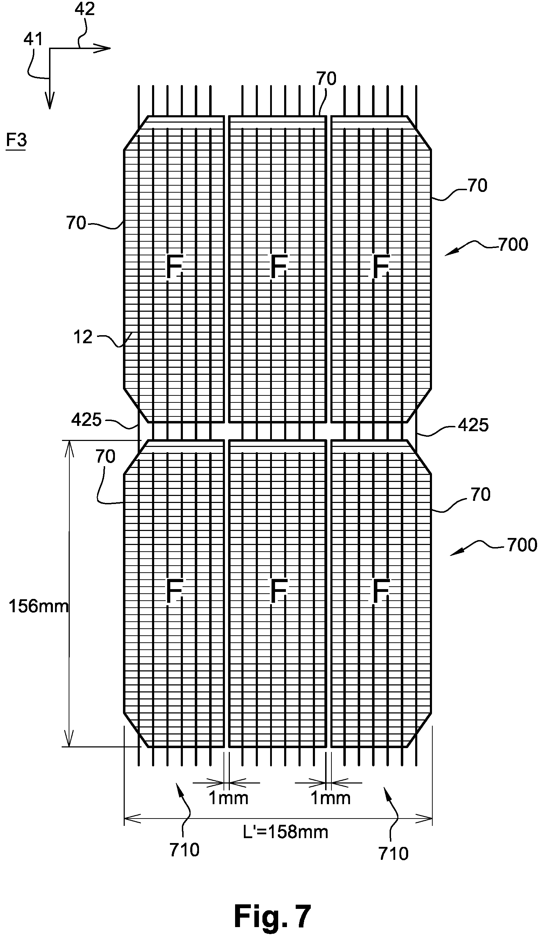

La figure 7 illustre un deuxième mode de mise en œuvre du procédé selon l'invention ne faisant pas intervenir le découpage en demi-cellules. En effet, les cellules photovoltaïques de pleine taille sont ici découpées dans la première direction 41 seulement, c'est-à-dire perpendiculairement aux doigts de collecte 12, obtenant ainsi des sous-cellules 70 en forme de bande, par exemple trois bandes de 52 mm x 156 mm.

Des groupes 700 de sous-cellules 70 sont constitués à l'étape F2 de la même façon que décrite précédemment, à la différence que les groupes 700 ont des dimensions semblables à celles de cellules entières (par exemple 158 mm x 156 mm). Ainsi, plutôt qu'un stringer de demi-cellules, on utilisera un stringer de cellules entières avec la même modification au niveau des buses d'aspiration et du logiciel de vision. Ceci est particulièrement avantageux, car les stringers de cellules entières sont nettement plus répandus et moins chers que les stringers de demi-cellules et ont une meilleure cadence de production. À l'inverse, les gains en tension seront plus limités, de même que la réduction des pertes résistives dans les interconnexions.

Les autres étapes du procédé de fabrication, en particulier l'étape F3 d'interconnexions des sous-cellules 70 en chaînes 710, pourront être mises en œuvre comme indiqué précédemment. Seule la longueur des interconnexions 425 est adaptée à la largeur plus importante des sous-cellules 70.

Grâce au procédé de fabrication qui vient d'être décrit, un module photovoltaïque de tension élevée et de courant faible peut être obtenu facilement et à moindre coût. À surface de cellule équivalente, la tension de circuit ouvert du module est multipliée d'un facteur égal au nombre de sous-cellules découpées dans une cellule de pleine taille. Le courant électrique du module est quant à lui diminué dans les mêmes proportions.

Par exemple, en découpant en 6 (soit 3 sous-cellules par demi-cellule) les 60 cellules photovoltaïques de pleine taille d'un module classique, le module selon l'invention peut atteindre une tension de circuit ouvert supérieure à 220 V dans le cas de cellules à homojonction, et supérieure à 250 V dans le cas de cellules à hétérojonction. À partir de 8 sous-cellules par cellule photovoltaïques de pleine taille (soit 4 sous-cellules par demi-cellule), la tension de circuit ouvert est supérieure à 300 V dans le cas de cellules à homojonction, et supérieure à 340 V dans le cas de cellules à hétérojonction.

Les cellules élémentaires, ou sous-cellules, du module photovoltaïque selon l'invention ont avantageusement une largeur l (dans la direction 41) inférieure ou égale à la dimension standard des cellules photovoltaïques (ex. 156 mm), et une longueur $L_{sc}$ (dans la direction 42) strictement inférieure à leur largeur. Cela est dû au fait que les sous-cellules ont été obtenues en découpant des cellules photovoltaïques de pleine taille perpendiculairement aux doigts de collecte. Le module photovoltaïque comporte alors moins d'espacements entre les sous-cellules d'une même chaîne que dans un module où les sous-cellules auraient été découpées parallèlement aux doigts de collecte. La puissance électrique du module par unité de surface est ainsi augmentée. Le fait que le module selon l'invention comporte par contre plus de chaînes, et donc plus d'espacements entre ces chaînes, n'est pas gênant car ces espacements sont plus faibles que ceux entre les sous-cellules d'une chaîne (environ 1 mm, en comparaison de 2,5 mm entre les sous-cellules).

Dans le mode de réalisation préférentiel des figures 4A à 4E, la largeur l des sous-cellules 40 est égale à la largeur d'une demi-cellule, soit 78 mm, et la longueur $L_{sc}$ des sous-cellules 40 varie selon le nombre de sous-cellules découpées dans chaque cellule 10. La longueur $L_{sc}$ des sous-cellules est de préférence comprise entre 30,6 mm et 52,5 mm, ce qui correspond à 3-5 sous-cellules par groupe 400, en tenant compte que certaines cellules du groupe peuvent avoir une longueur plus grande que d'autres. En effet, la borne supérieure « 52,5 mm » est la longueur maximale des sous-cellules au format 1/6 dans le cas de cellules pseudo-carrées (52 mm pour des cellules carrées) et la borne inférieure « 30,6 mm » est la longueur minimale des sous-cellules au format 1/10 dans le cas de cellules pseudo-carrées (31,2 pour des cellules carrées).

L'obtention d'un module photovoltaïque de tension élevée et de courant faible présente de nombreux avantages. Un courant électrique moindre équivaut à des pertes résistives dans les interconnexions du module plus faibles comparées aux modules classiques, et donc à un meilleur facteur de forme FF. Les pertes résistives dans les conducteurs de l'installation photovoltaïque, par exemple entre deux modules consécutifs d'une chaîne de modules, sont également diminuées. Par ailleurs, le fait de disposer d'une tension plus élevée en sortie du module permet d'équiper chaque module photovoltaïque d'un micro-onduleur, car ce dernier n'a plus besoin d'élever la tension du module au niveau de la tension du réseau. Auparavant, cette solution n'était pas envisageable avec les modules classiques en raison du coût important des micro-onduleurs. Dans la mesure où l'étage élévateur de tension des micro-onduleurs est supprimé, leur coût est réduit et on peut prévoir un onduleur par module, plutôt qu'un seul onduleur pour toute une chaîne de modules. Un module photovoltaïque ayant son propre onduleur est particulièrement intéressant, car il est ainsi moins sensible aux perturbations que peut subir le module, par exemple un ombrage partiel.

Bien sûr, chaque cellule photovoltaïque ou demi-cellule peut être découpée en nombre plus important de sous-cellules, par exemple 6, afin de diminuer davantage le courant électrique du module, et donc les pertes résistives. Toutefois, plus ce nombre est grand, plus le taux de recombinaison des porteurs de charge dans le groupe de sous-cellules est important, par rapport à une cellule ou une demi-cellule de taille équivalente. En effet, un groupe de sous-cellules comporte de nombreux bords où se concentrent les recombinaisons de porteurs de charge. Le meilleur compromis entre la diminution du courant électrique du module et les pertes par recombinaison des porteurs de charge est atteint pour des sous-cellules ayant un ratio largeur sur longueur compris entre 1,48 et 2,55. Un ratio largeur sur longueur de 1,48 correspond à la découpe de trois sous-cellules 40 par demi-cellule 30 (Fig.4A) ou de trois sous-cellules 70 par cellule photovoltaïque 10 de pleine taille (Fig.7). Un ratio largeur sur longueur de 2,55 correspond à la découpe de cinq sous-cellules 40 par demi-cellule 30 ou de cinq sous-cellules 70 par cellule photovoltaïque 10 de pleine taille.

Le procédé de fabrication selon l'invention permet également d'obtenir des modules photovoltaïques dont les performances et la fiabilité sont accrues par rapport aux modules photovoltaïques à cellules entières ou à demi-cellules de l'art antérieur. Ces améliorations sont obtenues en redimensionnant les interconnexions 420A-420C utilisées à l'étape F3 de stringing (Figs.4C, 5C et 7). En effet, puisque le courant électrique est plus faible, la section des interconnexions peut être diminuée sans rogner de façon trop significative les gains en termes de pertes résistives (obtenus par la diminution du courant électrique).

Les fils conducteurs utilisés à l'étape F3 dans le cadre de la technologie « SmartWire » et « MultiBusbar » ont avantageusement un diamètre inférieur ou égal à 200 μm, et de préférence inférieur ou égal à 180 μm. Lorsque les rubans conducteurs sont utilisés, ils ont avantageusement une largeur inférieure ou égale à 1 mm, par exemple de 0,8 mm, et une épaisseur inférieure ou égale à 180 μm. Dans les modules photovoltaïques de l'art antérieur, ils ont habituellement une largeur de 1,5 mm (configuration à 3 busbars) ou une largeur de 1,2 mm (configuration à 4 busbars), et une épaisseur supérieure ou égale à 200 μm.

À titre d'exemple, dans un module photovoltaïque classique comprenant une chaîne de cellules photovoltaïques entières (156 mm x 156 mm) connectées deux à deux par trois rubans de dimensions 1,5 mm x 0,2 mm, la section transversale (i.e. dans la direction 42) totale des interconnexions est égale à 0,9 mm² (soit 5,77.10⁻³ mm²/mm, en répartissant la section sur toute la longueur des cellules). À titre de comparaison, dans un module photovoltaïque comprenant trois chaînes de sous-cellules 52 mm x 78 mm (des sixièmes de cellule) connectées deux à deux par un seul ruban de dimensions 0,8 mm x 0,15 mm, la section transversale totale des interconnexions est égale à 0,36 mm² (soit 2,31.10⁻³ mm²/mm, en répartissant la section sur la longueur cumulée des sous-cellules). La section transversale est ainsi réduite de 60 % environ.

Dans le cas des interconnexions par fils, la technologie « SmartWire » est habituellement mise en œuvre sur des cellules photovoltaïques entières (156 mm x 156 mm) avec 18 fils de 300 μm de diamètre afin d'obtenir les meilleures performances. La section transversale totale de ces interconnexions est alors égale à 1,27 mm² (soit 8,14.10⁻³ mm²/mm). Grâce au procédé selon l'invention, des sixièmes de cellule (52 mm x 78 mm) peuvent être connectées (deux à deux) par six fils de 150 μm de diamètre ou quatre fils de 180 μm de diamètre. La section transversale totale de conducteur est alors de 0,31 mm² environ (soit 2,0.10⁻³ mm²/mm), ce qui représente une réduction d'environ 75 %.

Pour la réalisation de modules photovoltaïques à base de sous-cellules bifaciales, qui délivrent plus de courant du fait de la contribution de la face arrière, on peut utiliser une section d'interconnexion légèrement plus élevée. Par exemple, des sixièmes de cellule (52 mm x 78 mm) peuvent être connectées (deux à deux) par quatre fils de 200 μm de diamètre, au lieu de 180 μm. La section transversale totale de conducteur est alors de 0,37 mm² environ (soit 2,4.10⁻³ mm²/mm).

Des réductions de section transversale peuvent aussi être obtenues avec des cellules entières découpées en 4, 8 ou 10 sous-cellules, plutôt qu'en 6, avec des réductions plus marquées en augmentant le nombre de sous-cellules. Ainsi, lorsqu'on compte 3 à 5 sous-cellules par groupe, les fils électriques ont avantageusement dans chaque sous-cellule une section transversale rapportée sur la longueur $L_{sc}$ de la sous-cellule inférieure à 0,0025 mm²/mm, et de préférence inférieure à 0,0021 mm²/mm.

La réduction de la section des interconnexions conduit à une diminution des contraintes de dilatation thermique dans les interconnexions et, par conséquent, à une meilleure fiabilité des modules photovoltaïques. Les interconnexions sont également plus souples, ce qui permet de rapprocher davantage les différents groupes de sous-cellules afin de réaliser des modules plus compacts. Par exemple, l'espace entre deux groupes de sous-cellules consécutifs peut être inférieur à 1,3 mm en utilisant des fils de diamètre 150 μm ou moins. Autrement dit, les sous-cellules de chaque chaîne sont régulièrement espacées dans la direction 41 d'une distance inférieure ou égale à 1,3 mm, par exemple 1 mm. Dans la direction 42, les chaînes de sous-cellules sont avantageusement espacées deux à deux d'une distance inférieure ou égale à 1,0 mm.

Réduire la section des interconnexions permet en outre, dans le cas des fils conducteurs, de diminuer le coût de fabrication du module. En effet, on réduit ainsi la quantité de l'alliage qui recouvre les âmes en cuivre des fils et qui permet leur soudure sur les busbars ou les doigts de collecte. Ceci est particulièrement vrai pour la technologie « SmartWire » où le revêtement des fils conducteurs est à base d'indium, un matériau dont le prix est très élevé. Par exemple, en passant de fils de 300 μm de diamètre à des fils de 150 μm de diamètre, la quantité d'indium est divisée par deux (l'épaisseur de la couche d'alliage est constante, seul son périmètre diminue).

La réduction de la section des interconnexions entraîne également une augmentation de la puissance électrique des modules photovoltaïques, car l'ombrage causé par les interconnexions est moindre. Ainsi, les sous-cellules produisent davantage de courant pour un même ensoleillement. Ces gains en courant sont encore plus significatifs avec des fils conducteurs car, du fait de leur forme cylindrique, l'ombrage effectif ne correspond qu'à 70 % du diamètre de fils. Par exemple, pour un fil de 150 μm de diamètre, l'ombrage réel n'est que de 105 μm de largeur.

Ainsi, lorsque le procédé de fabrication selon l'invention est combiné avec la technologie d'interconnexion « SmartWire », des modules photovoltaïques de grande fiabilité (pas de contraintes lors de la manipulation des chaînes, peu de contraintes de dilatation thermique) et de hautes performances (pertes résistives, ombrage) peuvent être obtenus à bas coût (quantités d'argent et d'indium plus faibles).

Naturellement, le procédé de fabrication selon l'invention n'est pas limité aux modes de réalisation décrits en référence aux figures 4 à 7 et d'autres variantes apparaîtront à l'homme du métier. En particulier, le procédé de fabrication est applicable à tous types de cellules photovoltaïques, à homojonction ou hétérojonction, à base de silicium (monocristallin, multicristallin, amorphe).

**Revendications**

1. Procédé de fabrication d'un module photovoltaïque comprenant successivement les étapes suivantes :

   - prévoir des cellules photovoltaïques (10) comportant des doigts de collecte (12) ;
   - découper (F1) les cellules photovoltaïques (10) selon une première direction (41) perpendiculaire aux doigts de collecte pour former une pluralité de sous-cellules (40, 70) ;

- aligner (F2) des sous-cellules (40, 70) dans une deuxième direction (42) perpendiculaire à la première direction (41), de façon à constituer des groupes (400, 700) de sous-cellules isolées électriquement, chaque groupe de sous-cellules ayant une dimension (L') dans la deuxième direction (42) sensiblement identique à la dimension (L) des cellules photovoltaïques (10) dans la deuxième direction ;

- former (F3) simultanément une pluralité de chaînes (410, 710) de sous-cellules connectées en série, en alignant successivement les groupes (400, 700) de sous-cellules (40, 70) dans la première direction (41) et en interconnectant les groupes (400, 700) de sous-cellules (40, 70) alignés, les sous-cellules (40, 70) de chaque groupe (400, 700) étant saisies simultanément et appartenant à des chaînes (410, 710) de sous-cellules différentes ; et

- connecter (F4-F5) électriquement en série les chaînes (410, 710) de sous-cellules (40, 70).

2. Procédé selon la revendication 1, dans lequel les sous-cellules (40) sont obtenues en découpant les cellules photovoltaïques (10) une fois selon la deuxième direction (42) et au moins une fois selon la première direction (41).

3. Procédé selon la revendication 2, dans lequel les cellules photovoltaïques (10) sont découpées selon la deuxième direction (42) en deux demi-cellules (30) de même superficie et dans lequel les demi-cellules (30) sont découpées selon la première direction (41) pour former les sous-cellules (40).

4. Procédé selon l'une quelconque des revendications 1 à 3, dans lequel les groupes (400, 700) de sous-cellules (40, 70) sont interconnectés deux par deux au moyen de fils électriques (420A) de sorte que chaque face (F, B) des sous-cellules soit en contact avec une pluralité de fils électriques (420A).

5. Procédé selon la revendication 4, dans lequel les fils électriques (420A) sont solidaires d'un support en matériau polymère et contactent les doigts de collecte (12) des sous-cellules (40).

6. Procédé selon la revendication 5, dans lequel les groupes (400) de sous-cellules (40) sont interconnectés en plaquant une feuille de support (430A) de part et d'autre de chaque groupe de sous-cellules, les fils électriques (420A) étant répartis à la surface de chaque feuille de support en contact avec le groupe de sous-cellules, et dans lequel les feuilles de support (430A) sont ultérieurement découpées pour séparer les différentes chaînes (410) de sous-cellules (40).

7. Procédé selon la revendication 5, dans lequel les groupes (400) de sous-cellules (40) sont interconnectés en plaquant plusieurs morceaux distincts (430') du support de part et d'autre de chaque groupe de sous-cellules, des fils électriques (420A) étant répartis à la surface de chaque morceau du support en contact avec le groupe de sous-cellules, et dans lequel chaque morceau (430') du support appartient à une seule chaîne (410) de sous-cellules (40).

8. Procédé selon l'une quelconque des revendications 4 à 7, dans lequel les fils électriques (420A) ont un diamètre inférieur ou égal à 200 $\mu$m.

9. Procédé selon l'une quelconque des revendications 1 à 8, dans lequel les sous-cellules (40, 70) appartenant aux chaînes (410, 710) de sous-cellules connectées en série sont d'un même type et orientées dans un même sens.

10. Procédé selon l'une quelconque des revendications 1 à 8, dans lequel les sous-cellules (40, 70) appartenant à une première chaîne (410, 710) et les sous-cellules appartenant à une deuxième chaîne (410, 710) adjacente à la première chaîne sont de types opposés ou orientées dans des sens opposés.

11. Système permettant d'interconnecter des portions (40, 70) de cellule photovoltaïque, les portions de cellule photovoltaïque comprenant des doigts de collecte (12) orientés perpendiculairement à une première direction (41), **caractérisé en ce qu'**il comporte :

- une station de chargement configurée pour distribuer des groupes (400, 700) de plusieurs portions de cellule isolées électriquement et alignées dans une deuxième direction (42) perpendiculaire à la première direction (41), chaque groupe (400, 700) de portions de cellule ayant une dimension (L') dans la deuxième direction (42) sensiblement identique à la dimension (L) de la cellule photovoltaïque dans la deuxième direction (42) ;

- une station d'assemblage configurée pour interconnecter dans la première direction (41) les groupes (400, 700) de portions de cellule (40, 70) de façon à former simultanément une pluralité de chaînes (410, 710) de portions de cellule, les portions de cellule de chaque groupe appartenant à des chaînes de portions de cellule différentes ;

- une première unité de transfert configurée pour appréhender chaque groupe (400, 700) de portions de cellule et déplacer ledit groupe de portions de cellule de la station de chargement vers la station d'assemblage, les portions de cellule (40, 70) de chaque groupe (400, 700) étant saisies simultanément.

**12.** Système selon la revendication 11, dans lequel la première unité de transfert comprend des buses d'aspiration configurées pour aspirer simultanément toutes les portions de cellule (40, 70) dudit groupe (400, 700).

**13.** Système selon l'une des revendications 11 et 12, comprenant une station de découpe de cellules photovoltaïques (10) en portions de cellule (40, 70), située en amont de la station de chargement.

**14.** Système selon l'une quelconque des revendications 11 à 13, comprenant un module de distribution de fils électriques (420A) solidaires d'un support (430A) et dans lequel la station d'assemblage est configurée pour lier mécaniquement le support des fils électriques aux groupes (400, 700) de portions de cellule (40, 70).

**15.** Système selon la revendication 14, comprenant un dispositif de découpe configuré pour découper le support (430A) des fils électriques (420A) après l'assemblage des groupes (400, 700) de portions de cellule (40, 70), de manière à séparer les chaînes (410, 710) de portions de cellule.

**16.** Système selon l'une quelconque des revendications 11 à 15, comprenant une deuxième unité de transfert configurée pour saisir individuellement chacune des chaînes (410, 710) de portions de cellule (40, 70) issues de la station d'assemblage et pour tourner à 180° ladite chaîne saisie.

**17.** Système selon l'une quelconque des revendications 11 à 15, comprenant une deuxième unité de transfert configurée pour saisir collectivement plusieurs chaînes (410, 710) de portions de cellule (40, 70) issues de la station d'assemblage, pour libérer une première partie desdites chaînes saisies et pour tourner à 180° une deuxième partie restante desdites chaînes saisies.

**Patentansprüche**

**1.** Herstellungsverfahren eines photovoltaischen Moduls, umfassend nacheinander die folgenden Schritte:

- Vorsehen der photovoltaischen Zellen (10), die Sammelfinger (12) umfassen,
- Zuschneiden (F1) der photovoltaischen Zellen (10) gemäß einer ersten, zu den Sammelfingern lotrechten Richtung (41) zum Bilden einer Vielzahl von Teilzellen (40, 70);
- Fluchten (F2) der Teilzellen (40, 70) in einer zweiten, zur ersten Richtung (41) lotrechten Richtung (42) derart, dass Gruppen (400, 700) von elektrisch isolierten Teilzellen gebildet werden, wobei jede Gruppe von Teilzellen eine Abmessung (L') in der zweiten Richtung (42) aufweist, die zur Abmessung (L) der photovoltaischen Zellen (10) in der zweiten Richtung deutlich identisch ist,
- gleichzeitiges Bilden (F3) einer Vielzahl von Ketten (410, 710) von in Serie angeschlossenen Teilzellen durch Fluchten der Gruppen (400, 700) von Teilzellen (40, 70) nacheinander in der ersten Richtung (41) und miteinander Verschalten der Gruppen (400, 700) von gefluchteten Teilzellen (40, 70), wobei die Teilzellen (40, 70) jeder Gruppe (400, 700) gleichzeitig ergriffen werden und zu unterschiedlichen Ketten (410, 710) von Teilzellen gehören; und
- elektrisches Anschließen (F4-F5) der Ketten (410, 710) von Teilzellen (40, 70) in Serie.

**2.** Verfahren gemäß Anspruch 1, bei dem die Teilzellen (40) durch Zuschneiden der photovoltaischen Zellen (210) einmal gemäß der zweiten Richtung (42) und wenigstens einmal gemäß der ersten Richtung (41) erhalten werden.

**3.** Verfahren gemäß Anspruch 2, bei dem die photovoltaischen Zellen (10) gemäß der zweiten Richtung (42) in zwei Halbzellen (30) mit derselben Oberfläche ausgeschnitten werden und bei dem die Halbzellen (30) gemäß der ersten Richtung (41) ausgeschnitten werden, um die Teilzellen (40) zu bilden.

**4.** Verfahren gemäß irgendeinem der Ansprüche 1 bis 3, bei dem die Gruppen (400, 700) von Teilzellen (40, 70) jeweils zu zweit miteinander mittels elektrischer Drähte (420A) derart verschaltet sind, dass jede Seite (F, B) der Teilzellen mit einer Vielzahl von elektrischen Drähten (420A) in Kontakt ist.

**5.** Verfahren gemäß Anspruch 4, bei dem die elektrischen Drähte (420A) mit einem Träger aus einem Polymermaterial fest verbunden sind und die Sammelfinger (12) der Teilzellen (40) kontaktieren.

**6.** Verfahren gemäß Anspruch 5, bei dem die Gruppen (400) von Teilzellen (40) durch Andrücken eines Trägerblattes (430A) auf jeder Seite jeder Gruppe von Teilzellen miteinander verschaltet werden, wobei die elektrischen Drähte (420A) an der Oberfläche jedes Trägerblattes mit der Gruppe von Teilzellen in Kontakt ist, und bei dem die Trägerblätter (430A) später zugeschnitten werden, um die unterschiedlichen Ketten (410) von Teilzellen (40) zu trennen.

**7.** Verfahren gemäß Anspruch 5, bei dem die Gruppen (400) von Teilzellen (40) miteinander durch Andrücken mehrerer verschiedener Stücke (430') des Trägers auf jeder Seite jeder Gruppe von Teilzellen verschaltet sind, wobei elektrische Drähte (420A) an der Oberfläche jedes Stücks des Trägers mit der Gruppe von Teilzellen in Kontakt sind, und bei dem jedes Stück (430') des Trägers zu einer einzigen Kette (410) von Teilzellen (40) gehört.

**8.** Verfahren gemäß irgendeinem der Ansprüche 4 bis 7, bei dem die elektrischen Drähte (420A) einen Durchmesser von weniger als oder gleich 200 μm aufweisen.

**9.** Verfahren gemäß irgendeinem der Ansprüche 1 bis 8, bei dem die Teilzellen (40, 70), die zu den Ketten (410, 710) von Teilzellen gehören, die in Serie angeschlossen sind, vom selben Typ und in einer und derselben Richtung ausgerichtet sind.

**10.** Verfahren gemäß irgendeinem der Ansprüche 1 bis 8, bei dem die Teilzellen (40, 70) zu einer ersten Kette (410, 710) gehören und die Teilzellen, die zu einer zweiten, der ersten Kette anliegenden Kette (410, 710) gehören, von entgegengesetzten Typen oder in der entgegengesetzten Richtung ausgerichtet sind.

**11.** System, das das Verschalten der Abschnitte (40, 70) von photovoltaischen Zellen miteinander zulässt, wobei die Abschnitte von photovoltaischen Zellen Sammelfinger (12) umfassen, die lotrecht zu einer ersten Richtung (41) ausgerichtet sind, **dadurch gekennzeichnet, dass** es umfasst.

- eine Ladestation, die ausgestaltet ist, um Gruppen (400, 700) von mehreren Zellabschnitten zu verteilen, die elektrisch isoliert und in einer zweiten Richtung (42) gefluchtet sind, die lotrecht zur ersten Richtung (41) ist, wobei jede Gruppe (400, 700) von Zellabschnitten eine Abmessung (L') in der zweiten Richtung (42) aufweist, die zu der Richtung (L) der photovoltaischen Zelle in der zweiten Richtung (42) deutlich identisch ist;
- eine Montagestation, die zum Verschalten der Gruppen (400, 700) von Zellabschnitten (40, 70) miteinander in der ersten Richtung (41) derart ausgestaltet ist, dass gleichzeitig eine Vielzahl von Ketten (410, 710) von Zellabschnitten gebildet ist, wobei die Zellabschnitte jeder Gruppe zu unterschiedlichen Ketten von Zellabschnitten gehören;
- eine erste Übertragungseinheit, die zum Ergreifen jeder Gruppe (400, 700) von Zellabschnitten und Versetzen der genannten Gruppe von Zellabschnitten von der Ladestation zur Montagestation ausgestaltet ist, wobei die Zellabschnitte (40, 70) jeder Gruppe (400, 700) gleichzeitig ergriffen sind.

**12.** System gemäß Anspruch 11, bei dem die erste Übertragungseinheit Ansaugdüsen umfasst, die zum gleichzeitigen Ansaugen aller Zellabschnitte (40, 70) der genannten Gruppe (400, 700) ausgestaltet sind.

**13.** System gemäß einem der Ansprüche 11 und 12, umfassend eine Zuschneidestation von photovoltaischen Zellen (10) in Zellabschnitte (40, 70), die der Ladestation vorgeschaltet ist.

**14.** System gemäß irgendeinem der Ansprüche 11 bis 13, umfassend ein Verteilermodul von elektrischen Drähten (420A), die mit einem Träger (430A) fest verbunden sind und bei dem die Montagestation zum mechanischen Verbinden des Trägers der elektrischen Drähte mit den Gruppen (400, 700) von Zellabschnitten (40, 70) ausgestaltet ist.

**15.** System gemäß Anspruch 14, umfassend eine Zuschneidevorrichtung, die zum Zuschneiden des Trägers (430A) der elektrischen Drähte (420A) nach dem Zusammenbau der Gruppen (400, 700) von Zellabschnitten (40, 70) derart ausgestaltet ist, dass die Ketten (410, 710) von Zellabschnitten getrennt werden.

**16.** System gemäß irgendeinem der Ansprüche 11 bis 15, umfassend eine zweite Übertragungseinheit, die zum individuellen Ergreifen jeder Kette (410, 710) von Zellabschnitten (40, 70) ausgestaltet ist, die aus der Montagestation hervorgegangen sind und um die genannte ergriffene Kette um 180° zu drehen.

**17.** System gemäß irgendeinem der Ansprüche 11 bis 15, umfassend eine zweite Übertragungseinheit, die zum kollektiven Ergreifen mehrerer Ketten (410, 710) von Zellabschnitten (40, 70) ausgestaltet ist, die aus der Montagestation hervorgegangen sind, um einen ersten Teil der genannten ergriffenen Ketten freizugeben und um einen zweiten, verbleibenden Teil der genannten ergriffenen Ketten um 180° zu drehen.

**Claims**

**1.** Method for manufacturing a photovoltaic module successively comprising the following steps of:

- providing photovoltaic cells (10) comprising collecting fingers (12);
- cutting (F1) the photovoltaic cells (10) along a first direction (41) perpendicular to the collecting fingers to form a plurality of sub-cells (40, 70);

- aligning (F2) sub-cells (40, 70) in a second direction (42) perpendicular to the first direction (41), so as to constitute groups (400, 700) of electrically insulated sub-cells, each group of sub-cells having a dimension (L') in the second direction (42) substantially identical to the dimension (L) of the photovoltaic cells (10) in the second direction;

- simultaneously forming (F3) a plurality of strings (410, 710) of series-connected sub-cells, by successively aligning the groups (400, 700) of sub-cells (40, 70) in the first direction (41) and interconnecting the aligned groups (400, 700) of sub-cells (40, 70), the sub-cells (40, 70) of each group (400, 700) being simultaneously gripped and belonging to different strings (410, 710) of sub-cells; and

- electrically connecting (F4-F5) in series the strings (410, 710) of sub-cells (40, 70).

2. Method according to claim 1, wherein the sub-cells (40) are obtained by cutting the photovoltaic cells (10) once along the second direction (42) and at least once along the first direction (41).

3. Method according to claim 2, wherein the photovoltaic cells (10) are cut along the second direction (42) into two half-cells (30) of a same surface area and wherein the half-cells (30) are cut along the first direction (41) to form the sub-cells (40).

4. Method according to any of claims 1 to 3, wherein the groups (400, 700) of sub-cells (40, 70) are interconnected two by two by means of electrical wires (420A) so that each face (F, B) of the sub-cells is in contact with a plurality of electrical wires (420A).

5. Method according to claim 4, wherein the electrical wires (420A) are attached to a support of polymeric material and contact the collecting fingers (12) of the sub-cells (40).

6. Method according to claim 5, wherein the groups (400) of sub-cells (40) are interconnected by pressing a support sheet (430A) on either side of each group of sub-cells, the electrical wires (420A) being distributed at the surface of each support sheet in contact with the group of sub-cells, and wherein the support sheet (430A) are subsequently cut to separate the different strings (410) of sub-cells (40).

7. Method according to claim 5, wherein the groups (400) of sub-cells (40) are interconnected by pressing several distinct pieces (430') of the support on either side of each group of sub-cells, electric wires (420A) being distributed at the surface of each piece of the support in contact with the group of sub-cells, and wherein each piece (430') of the support belongs to a single string (410) of sub-cells (40).

8. Method according to any of claims 4 to 7, wherein the electrical wires (420A) have a diameter lower than or equal to 200$\mu$m.

9. Method according to any of claims 1 to 8, wherein the sub-cells (40, 70) belonging to the strings (410, 710) of series-connected sub-cells are of a same type and oriented in a same sense.

10. Method according to any of claims 1 to 8, wherein the sub-cells (40, 70) belonging to a first string (410, 710) and the sub-cells belonging to a second string (410, 710) adjacent to the first string are of opposite types or oriented in opposite senses.

11. System for interconnecting photovoltaic cell portions (40, 70), the photovoltaic cell portions comprising collecting fingers (12) oriented perpendicular to a first direction (41), **characterised in that** it comprises:

- a loading station configured to dispense groups (400, 700) of several electrically insulated cell portions aligned in a second direction (42) perpendicular to the first direction (41), each group (400, 700) of cell portions having a dimension (L') in the second direction (42) substantially identical to the dimension (L) of the photovoltaic cell in the second direction (42);

- an assembling station configured to interconnect in the first direction (41) the groups (400, 700) of cell portions (40, 70) so as to simultaneously form a plurality of strings (410, 710) of cell portions, the cell portions of each group belonging to different strings of cell portions;

- a first transfer unit configured to catch each group (400, 700) of cell portions and move said group of cell portions from the loading station to the assembling station, the cell portions (40, 70) of each group (400, 700) being simultaneously gripped.

12. System according to claim 11, wherein the first transfer unit comprises suction nozzles configured to simultaneously suck all the cell portions (40, 70) of said group (400, 700).

13. System according to one of claims 11 and 12, comprising a station for cutting photovoltaic cells (10) into cell portions (40, 70), located upstream of the loading station.

14. System according to any of claims 11 to 13, comprising a module for dispensing electric wires (420A) that are attached to a support (430A) and wherein the assembling station is configured to mechanically connect the support of electrical wires to the groups (400, 700) of cell portions (40, 70).

15. System according to claim 14, comprising a cutting device configured to cut the support (430A) of electrical wires (420A) after assembling the groups (400, 700) of cell portions (40, 70), so as to separate the strings (410, 710) of cell portions.

16. System according to any of claims 11 to 15, comprising a second transfer unit configured to individually grip each of the strings (410, 710) of cell portions (40, 70) coming from the assembling station and to rotate said gripped string by 180°.

17. System according to any of claims 11 to 15, comprising a second transfer unit configured to collectively grip several strings (410, 710) of cell portions (40, 70) coming from the assembling station, to release a first part of said gripped strings and to rotate a second remaining part of said gripped strings by 180°.

**Fig. 1**

**Fig. 2**

**Fig. 3**

**Fig. 4A**

42

41

F2

L'=158mm

1mm   1mm

40

F   F   F

ℓ'=78mm

400

40

F   F   F

ℓ'=78mm

40   40

400

# Fig. 4B

**Fig. 4C**

**Fig. 4D**

Fig. 4E

Fig. 5C

**Fig. 6**

**Fig. 7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2013020111 A
- US 2013139871 A
- DE 102008043833
- DE 102012220221
- US 2007294883 A
- US 2003127124 A

**Littérature non-brevet citée dans la description**

- **S. BRAUN et al.** Multi-busbar solar cells and modules: high efficiencies and low silver consumption. *Energy Procedia,* 2013, vol. 38, 334-339
- **T. SÖDERSTRÖM et al.** Smart Wire Connection Technology. *Proceedings of the 28th European Photovoltaics Solar Energy Conference,* 2013, 495-499